# EUROPEAN PATENT SPECIFICATION

(11) **EP 1 854 845 B1**
(45) Date of publication and mention of the grant of the patent: **06.04.2011**
(21) Application number: 06712929.6
(22) Date of filing: 02.02.2006
(51) Int. Cl.: C08L 81/02, B32B 27/00, C08K 7/00, C08L 63/00, C08L 71/12

(54) **RESIN COMPOSITION FOR ELECTRONIC AND ELECTRIC COMPONENTS FOR HIGH-FREQUENCY APPLICATIONS AND ITS MOLDED PRODUCT**
HARZZUSAMMENSETZUNG FÜR ELEKTRONISCHE UND ELEKTRISCHE BAUTEILE VON HOCHFREQUENZANWENDUNGEN UND GEFORMTES PRODUKT DARAUS
COMPOSITION DE RESINE POUR DES COMPOSANTS ELECTRONIQUES ET ELECTRIQUES DESTINES A DES APPLICATIONS HAUTE FREQUENCE ET SES PRODUITS MOULES

(30) Priority: 03.02.2005 JP 2005027734
(43) Date of publication of application: 14.11.2007
(73) Proprietor: Asahi Kasei Chemicals Corporation, Tokyo 100-8440 (JP)
(72) Inventor: TOYOUCHI, Kaoru c/o Corporate Intellectual Property, Tokyo 100-8440 (JP); AKIYAMA, Yoshikuni, Tokyo 100-8440 (JP)
(74) Representative: von Kreisler Selting Werner
(86) International application number: PCT/JP2006/301786
(87) International publication number: WO 2006/082902

(56) References cited:
- EP-A- 1 302 443
- JP-A- 5 339 500
- JP-A- 06 091 812
- JP-A- 07 316 419
- JP-A- 2002 012 764
- JP-A- 2002 223 075
- JP-A- 2003 136 628
- JP-A- 2004 195 755
- JP-A- 2004 231 697
- US-A1- 2004 266 951

## Description

### Technical Field

The present invention relates to a material of electronic and electric parts used, in particular, in high frequency bands. More specifically, the present invention relates to a resin composition for high-frequency electronic and electric parts employed for antenna substrates or filters used in the field of high frequency band telecommunications, and a shaped article using the same.

### Background Art

Recent progress in telecommunication devices utilizing radio waves, such as mobile phones, wireless LAN (Local Area Network), GPS (Global Positioning System) and ETC (Electronic Toll Collection System) is remarkable. With significant increase in the volume of information, telecommunication signals are becoming of high frequency and telecommunication devices are being downsized. Electronic and electric parts and circuit substrates of such telecommunication devices used in high frequency bands require excellent low dielectric loss properties. Since the dielectric loss generated in such parts and circuit substrates is proportional to the frequency of the signal and the product of the square root of the dielectric constant and the dielectric dissipation factor of a material constituting a part, basically a material having both low dielectric constant and low dielectric dissipation factor is needed. On the other hand, as for antenna substrates integrated into telecommunication devices, a material having high dielectric constant is needed since antenna substrates can be made smaller when a material having high dielectric constant is used. This is because the higher the dielectric constant of a material, the smaller the antenna substrate can be made, since the wavelength of signals transmitted through the substrate is shorter inversely proportional to the square root of the dielectric constant of the material. For this reason, for downsizing of antenna substrates, a special material having as low a dielectric dissipation factor as possible and a high dielectric constant at the same time is in demand.

Conventionally, substrates comprising a fluororesin, a BT (bismaleimidetriazine) resin or a thermosetting polyphenylene ether as a base are mainly used for circuit substrates of telecommunication devices used in high frequency bands in consideration of high frequency properties (low dielectric loss properties) and solder heat resistance.
A fluororesin copper-clad laminate conventionally used as a circuit substrate (see, for example, Patent Document 1) is prepared by repeating a step of impregnating a glass cloth with a fluororesin dispersion and baking, thereby preparing a prepreg which is a glass cloth sufficiently impregnated with a fluororesin, putting the prepreg and a plurality of fluororesin sheets together and stacking copper foil on the outermost face, and then subjecting the stacked material to hot pressing by a press as described in the document. The process, however, involves a complicated molding step and is also expensive and less productive due to batch molding. Also, since BT resins and thermosetting polyphenylene ethers, which are thermosetting resins, are cured and shaped by heating as fluororesins, batch molding by a hot press is required and so the productivity is poor. Under such circumstances, thermoplastic resin materials which retain properties necessary for circuit substrates and have such good processability (productivity) that they can be easily shaped by extrusion or injection molding are in demand. As thermoplastic resins having excellent heat resistance and low dielectric loss properties, polyarylene sulfide resins, polyphenylene ether resins, alloy resin compositions of a polyarylene sulfide resin and a polyphenylene ether resin (see, for example, Patent Document 2) and styrene resins having a syndiotactic structure are proposed.

For downsizing of antenna substrates, resin compositions having high dielectric constant have been proposed, in which the dielectric constant is improved by adding a ceramic metal oxide, typically Al₂O₃ (see, for example, Patent Document 3), an inorganic metal oxide, typically rutile titanium oxide (see, for example, Patent Document 4), or a fibrous metal titanate, typically barium titanate (see, for example, Patent Document 5) to the aforementioned thermosetting resin or thermoplastic resin as a filler having high dielectric constant and low dielectric dissipation factor. However, the above resin compositions have a disadvantage that the effect of improving dielectric constant is small unless a large amount of metal oxide is added, and consequently, mechanical properties (in particular, impact strength), injection moldabilities and sheet extrusion moldabilities are deteriorated.
Patent Document 1: JP-A-2002-307611
Patent Document 2: JP-A-7-316419
Patent Document 3: JP-A-2000-239515
Patent Document 4: JP-A-10-237303
Patent Document 5: JP-A-8-41247

US-A-2004/266951 discloses a resin composition comprising a polyphenylene sulfide resin, a polyphenylene ether resin, a copolymer of styrene as the main comonomer component and an unsaturated monomer containing an epoxy group and/or an oxazolyl group and an inorganic filler component. The compositions are used as secondary battery cases and as sheet or film for secondary batteries.

### Disclosure of the Invention

### Problems to be solved by the Invention

An object of the present invention is to provide a thermoplastic resin composition and a shaped article excellent in processability such as injection moldabilities and sheet extrusion moldabilities, solder heat resistance and mechanical properties (in particular, impact strength) and satisfying low dielectric loss necessary for high frequency band electric telecommunication parts.

### Means for Solving the Problems

The present inventors have conducted intensive studies on a resin composition and an extrusion molding sheet thereof excellent in processability and having excellent high frequency properties (low dielectric loss properties), solder heat resistance and mechanical properties. As a result, it has been found that a resin composition prepared by adding an appropriate amount of a specific graphite to an alloy resin composition composed of a polyarylene sulfide resin and a polyphenylene ether resin and a shaped article prepared by shaping the resin composition have high dielectric constant and low dielectric loss properties and are useful as an antenna substrate. It has also been found that by forming the shaped article of the resin composition prepared by adding a metal oxide to the alloy resin composition into a multilayer sheet structure, the resin composition has improved sheet extrusion moldabilities (drawdown resistance) and mechanical properties and is useful as an antenna substrate, which led to the completion of the present invention.

Accordingly, the present invention is directed to:
[1] A low dielectric loss resin composition for high-frequency electronic and electric parts, having dielectric properties of a dielectric constant of 3 to 10 and a dielectric dissipation factor of 0.007 or less at 1 GHz, wherein the resin composition is obtainable by melt kneading a raw material composition comprising:
   (a) 5 to 95% by weight of a polyarylene sulfide resin,
   (b) 95 to 5% by weight of a polyphenylene ether resin,
   (c) 1 to 20 parts by weight of a styrene copolymer comprising 65 % by weight or more of a styrene monomer and 0.3 to 20 % by weight of an unsaturated monomer containing an epoxy group and/or an oxazolyl group, based on 100 parts by weight of components (a) and (b), and
   (d) 1 to 15 parts by weight of graphite having an average particle size of 10 to 100 µm, based on 100 parts by weight of components (a), (b) and (c).
[2] The low dielectric loss resin composition according to item 1, wherein the raw material composition further comprises a thermoplastic elastomer selected from polybutadiene, polyisoprene, a styrene-butadiene copolymer, a butadiene-isoprene copolymer, an ethylene-propylene copolymer, a hydrogenated styrene-butadiene block copolymer, and a hydrogenated styrene-isoprene block copolymer.
[3] A shaped article prepared by shaping the resin composition according to item 1 or 2.
[4] The shaped article of item 3 being a single layer extruded sheet.
[5] A high-frequency multilayer sheet comprising an outer layer and an inner layer, wherein the outer layer and the inner layer are each composed of the shaped article according to item 3.
[6] The multilayer sheet according to item 5, wherein the inner layer is a shaped article prepared by shaping the resin composition according to item 1 or 2.
[7] The multilayer sheet according to item 5, wherein a raw material composition of the shaped article constituting the inner layer further comprises (e) 10 to 60 parts by weight of a metal oxide based on 100 parts by weight of components (a), (b) and (c).
[8] The multilayer sheet according to any one of items 5 to 7, wherein the multilayer sheet has an overall thickness of 0.01 to 5 mm and the outer layer has a thickness of 1/20 to 1/4 of the overall thickness of the multilayer sheet.
[9] The multilayer sheet according to any one of items 5 to 7, which is a copper-clad laminate.

### Advantages of the Invention

In the resin composition of the present invention to which graphite is added, the effect of increasing dielectric constant is significant and the dielectric constant can be improved by adding only a small amount of graphite. Accordingly, deterioration of mechanical properties (in particular, impact strength) and processability can be suppressed as much as possible with maintaining low dielectric dissipation factor, and thus the resin composition of the present invention is useful as an antenna substrate in which high dielectric constant and low dielectric loss properties are required.

Further, since the resin composition of the present invention is composed of a polyarylene sulfide resin and a polyphenylene ether resin, the resin composition has stable dielectric properties, linear expansion coefficient and rigidity even at high temperatures exceeding the glass transition temperature (about 90°C) of the polyarylene sulfide resin due to the effect of the polyphenylene ether resin having high glass transition temperature (about 220°C) compared to a resin composition composed of a polyarylene sulfide resin alone.

Further, since the polyphenylene ether resin effectively improves rheology and the viscosity of a molten composition, sheet extrusion moldabilities (drawdown resistance) are significantly improved compared to a resin composition composed of a polyarylene sulfide resin alone. However, when a large amount of a metal oxide is added, mechanical properties (in particular, impact strength) and sheet extrusion moldabilities (drawdown resistance) are deteriorated, making sheet extrusion difficult in the case of a single layer shaped article.

Since the extruded sheet of the present invention has such a structure that the outer layer is composed of a resin composition to which a metal oxide is not added and the inner layer is composed of a resin composition to which a metal oxide is added, sheet extrusion moldabilities (drawdown resistance) are improved and the outer layer effectively makes it possible to perform sheet extrusion. Further, the outer layer effectively improves surface smoothness and mechanical properties (in particular, impact strength).

### Brief Description of the Drawing

### [Figure 1]

Figure 1 is a schematic cross-sectional view of the polyarylene sulfide resin copper-clad laminate of Example 6 of the present invention.

### Description of Symbols

- 1: dielectric
- 2a: electrolytic copper foil
- 2b: electrolytic copper foil
- 3a: resin layer to which no titanium oxide is added
- 3b: resin layer to which titanium oxide is added

### Best Mode for Carrying Out the Invention

In the following, the present invention is described in detail.

The resin composition of the present invention is composed of (a) a polyarylene sulfide resin, (b) a polyphenylene ether resin and (c) a compatibility-imparting agent as main components.

The polyarylene sulfide resin (a) (hereinafter also abbreviated as "PAS") of the present invention is a polymer containing generally 50% by mole or more, preferably 70% by mole or more, more preferably 90% by mole or more of a repeat unit of arylene sulfide represented by the following formula (1).

[Formula 1] [-Ar - S-] (Ar represents an arylene group) (1)

Examples of arylene groups include a p-phenylene group, a m-phenylene group, a substituted phenylene group (preferred substituents being alkyl groups having 1 to 10 carbon atoms and phenyl groups), a p,p'-diphenylene sulfone group, a p,p'-biphenylene group, a p,p'-diphenylene carbonyl group and a naphthylene group. Herein, while a homopolymer containing a single type of an arylene group as the constituent of PAS may be used as PAS, a copolymer containing two or more types of arylene groups may also be used in consideration of processability and heat resistance. Of these PAS's, polyphenylene sulfide resins in which a repeat unit of p-phenylene sulfide is a main component are particularly preferred because they have excellent processability, heat resistance and dimensional stability, and are industrially readily available.

Examples of methods of preparing PAS generally include a method in which a halogen-substituted aromatic compound, for example, p-dichlorobenzene, is polymerized in the presence of sulfur and sodium carbonate, a method in which polymerization is performed in a polar solvent in the presence of sodium sulfide, or of sodium hydrogen sulfide plus sodium hydroxide or hydrogen sulfide plus sodium hydroxide, or of sodium aminoalkanoate, and a method of self condensation of p-chlorothiophenol. Of these, a method in which sodium sulfide and p-dichlorobenzene are reacted in an amide solvent such as N-methyl pyrrolidone or dimethylacetamide or a sulfone solvent such as sulfolane is preferred. These are known methods and for example, PAS can be prepared by methods described in U.S. Patent No. 2513188, JP-B-44-27671, JP-B-45-3368, JP-B-52-12240, JP-A-61-225217, U.S. Patent No. 3274165, JP-B-46-27255 and JP-A-5-222196 or conventional methods described in those patents.

In the present invention, a known PAS can also be suitably used as a crosslinked PAS (including semi-crosslinked PAS). The crosslinked PAS (including semi-crosslinked PAS) means a polymer whose molecular weight and viscosity are appropriately increased by facilitating oxidization and crosslinking by further heat treating linear PAS prepared by polymerizing the above PAS at the melting point or lower of PAS in the presence of oxygen. In the present invention, crosslinked PAS and linear PAS are preferably used. The crosslinked PAS may be used alone, the linear PAS may be used alone, or the crosslinked PAS and the linear PAS may be used in combination (crosslinked PAS/linear PAS of 1 to 99% by weight/99 to 1% by weight). Using a PAS whose volatile content collected in a molten state at 320°C is 1000 ppm or less of these crosslinked PAS's and linear PAS's improves lamination between a shaped article of the resulting resin composition and metal foil or metal plating, giving high-frequency electronic parts of high quality.

The volatile content collected in a molten state at 320°C can be determined by the following method. Specifically, 0.5 g of PAS powder is weighed and put into a test tube with a stopper and an air stream inlet and outlet; while dipping the tube in a solder bath heated at 320°C for 30 minutes, nitrogen gas is injected through the air stream inlet of the test tube at a flow rate of 100 cm³/minute, and gas containing volatile components derived from PAS generated in the tube is purged from the air stream outlet of the test tube; the purged gas is subjected to bubbling in acetone in a test tube containing acetone with a stopper and an air stream inlet and outlet, thereby dissolving the volatile components in acetone; the volatile components of PAS dissolved in acetone are subjected to programmed temperature gas chromatography at 50°C to 290°C using a gas chromatograph mass spectrometer (GC-MS) and the quantity of all the detected components is determined assuming that the components have the same sensitivity as that of monochlorobenzene, whereby the volatile content in crosslinked PPS is determined.

Of the PAS's described above, PAS's most preferred in the present invention are linear PAS's prepared by the above polymerization method. Of the linear PAS's, linear PAS's whose extract amount with methylene chloride is 0.7% by weight or less, preferably 0.5% by weight or less and containing 20 µmol/g or more, preferably 20 to 60 µmol/g of a terminal SX group (S representing a sulfur atom, X representing alkali metal or a hydrogen atom) are more preferred.

Herein, the extract amount with methylene chloride can be measured by the following method. Specifically, 5 g of linear PAS powder is added to 80 ml of methylene chloride and after performing Soxhlet extraction for 6 hours, the resultant is cooled to room temperature and the methylene chloride solution after extraction is transferred to a weighing bottle; the container used for the extraction is washed with a total of 60 ml of methylene chloride in three times and the wash liquid is collected in the weighing bottle; subsequently, the bottle is heated to 80°C to remove methylene chloride in the weighing bottle by evaporation and the residue is weighed; and the extraction amount with methylene chloride, i.e., the ratio of the amount of an oligomer present in linear PAS, can be determined from the amount of the residue.

The quantity of the terminal SX group herein described can be determined by the following method. Specifically, linear PAS powder is previously dried at 120°C for 4 hours and 20 g of the dried linear PAS powder is added to 150 g of N-methyl-2-pyrrolidone and the mixture is vigorously stirred at room temperature for 30 minutes until powder agglomerates disappear, thereby forming a slurry; after filtering the slurry, washing is repeated 7 times using 1 liter of warm water at 80°C each time; the resulting filtered cake is put in 200 g of pure water to prepare a slurry again, and then 1N hydrochloric acid is added thereto to adjust the pH of the slurry to 4.5.

Subsequently, after stirring the slurry at 25°C for 30 minutes and filtering, washing is repeated 6 times using 1 liter of warm water at 80°C each time; the resulting filtered cake is put in 200 g of pure water to prepare a slurry again and titration is performed with IN sodium hydroxide. The amount of the terminal SX group present in linear PAS can be determined from the amount of sodium hydroxide consumed.

Herein, specific examples of methods of preparing linear PAS satisfying the extract amount with methylene chloride of 0.7% by weight or less and the amount of a terminal SX group of 20 µmol/g or more include a method described in JP-A-8-253587 in which alkali metal sulfide and a dihaloaromatic compound are reacted in an organic amide solvent and the vapor phase in a reaction can is partly condensed by cooling the vapor phase portion of the reaction can during the reaction and the condensed part is allowed to reflow into the liquid layer in the upper part of the reaction solution to reduce the oligomer component.

Further, these PAS's (linear PAS, crosslinked PAS) may be acid modified. Acid modified PAS is prepared by modifying the above PAS with an acid compound. Examples of acid compounds include unsaturated carboxylic acid and anhydride thereof such as acrylic acid, methacrylic acid, maleic acid, fumaric acid and maleic anhydride, saturated aliphatic carboxylic acid and substituted aromatic carboxylic acid. Examples of acid compounds also include inorganic acid compounds such as acetic acid, hydrochloric acid, sulfuric acid, phosphoric acid, silicic acid and carbonic acid.

In the present invention, of the above-described PAS's, those having a melt viscosity at 300°C of preferably 0.1 to 1000 Pa·s (1 to 10000 poise), more preferably 5 to 800 Pa·S (50 to 8000 poise), particularly preferably 10 to 500 Pa·s (100 to 5000 poise) may be used. In the present invention, the melt viscosity is measured using FLOW TESTER (CFT-500 manufactured by Shimadzu Corporation) at a load of 196 N with die length(L)/ die diameter (D) of 10 mm/l mm after pre-heating PAS at 300°C for 6 minutes in accordance with JIS K-7210 as a reference test.

As the polyphenylene ether resin (b) (hereinafter also abbreviated as "PPE") in the present invention, a homopolymer or a copolymer composed of at least one structural unit selected from the formulas (2) and (3) may be used.

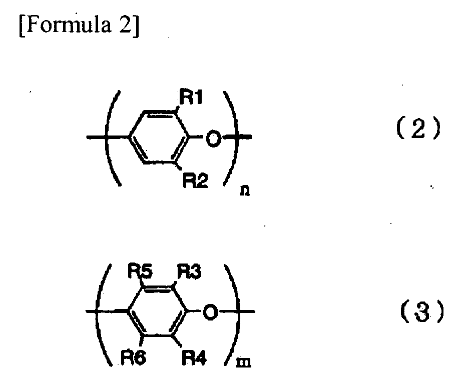

wherein R1, R2, R3, R4, R5 and R6 are a monovalent residue such as an alkyl group having 1 to 4 carbon atoms, an aryl group, a halogen or hydrogen, and R5 and R6 are not simultaneously hydrogen.

Typical examples of homopolymers of PPE include poly(2,6-dimethyl -1,4-phenylene) ether, poly(2-methyl-6-ethyl-1,4-phenylene) ether, poly(2,6-diethyl-1,4-phenylene) ether, poly(2-ethyl-6-n-propyl-1,4-phenylene) ether, poly(2,6-di-n-propyl-1,4-phenylene) ether, poly(2- methyl-6-n- butyl -1,4-phenylene) ether, poly(2-ethyl-6-isopropyl-1,4-phenylene) ether, poly(2-methyl-6-chloroethyl-1,4-phenylene) ether, poly(2-methyl-6-hydroxyethyl-1,4-phenylene) ether and poly(2-methyl-6-chloroethyl-1,4-phenylene) ether.

Copolymers of PPE include polyphenylene ether copolymers containing a polyphenylene ether structure as a main component, such as copolymers of 2,6-dimethylphenol and 2,3,6-trimethylphenol, copolymers of 2,6-dimethylphenol and o-cresol and copolymers of 2,6-dimethylphenol, 2,3,6-trimethylphenol and o-cresol. PPE has a reduced viscosity (measured at 0.5 g/dl in a chloroform solution at 30°C) of preferably 0.10 to 2.0. In addition to those described above, modified polyphenylene ether resin modified by α,β-unsaturated carboxylic acid such as maleic acid, maleic anhydride, fumaric acid, itaconic acid, acrylic acid, acrylic ester, methacrylic acid, methacrylic ester or a derivative thereof may be used.

Methods of preparing PPE are not particularly limited as long as PPE can be prepared by a known method. For example, PPE can be easily prepared by performing oxidative polymerization of 2,6-xylenol using a complex of cuprous salt and amine as a catalyst as described in U.S. Patent No. 3306874 issued to Hay. PPE can also be easily prepared by other methods such as methods described in U.S. Patent Nos. 3306875, 3257357 and 3257358, JP-B-52-17880, JP-A-50-51197 and JP-A-63-152628.

The polyphenylene ether resin of component (b) used in the present invention can be used with a PPE component ratio being 100% by weight as described above. However, in the present invention, a polyphenylene ether resin composed of PPE/styrene resin of 1 to 99% by weight/99 to 1 % by weight may be preferably used, and in particular, a polyphenylene ether resin composed of PPE/styrene resin of 20 to 80% by weight/80 to 20% by weight is more preferably used. Examples of such styrene resins include homopolymers of a styrene compound, copolymers of two or more styrene compounds and rubber modified styrene resins (high impact polystyrene) in which a rubbery polymer is dispersed in the form of particles in a matrix composed of a polymer of a styrene compound. Examples of styrene compounds which form such polymers include styrene, o-methylstyrene, p-methylstyrene, m-methylstyrene, α-methylstyrene, ethylstyrene, α-methyl-p-methylstyrene, 2,4-dimethylstyrene, monochlorostyrene and p-tert-butylstyrene.

As the styrene resin, copolymers prepared by using the above two or more styrene compounds in combination may be used. Polystyrene prepared by polymerization using only styrene is preferred. As these polymers, polystyrene having a stereoregular structure, such as atactic polystyrene and syndiotactic polystyrene can be effectively used.

The styrene resins used in combination with PPE do not include styrene copolymers such as styrene-glycidyl methacrylate copolymers, styrene-glycidyl methacrylate-methyl methacrylate copolymers, styrene-glycidyl methacrylate-acrylonitrile copolymers, styrene-vinyl oxazoline copolymers and styrene-vinyl oxazoline-acrylonitrile copolymers, which are compatibility-imparting agents used as component (g).

The PPE of component (b) described above is used for improving rheological properties of PAS of component (a). Mixing PPE prevents flashes in injection molding, significantly improves drawdown properties of molten materials in extrusion and thus makes it possible to prepare sheets of 100 µmm or more, which are difficult to prepare by extrusion with PAS alone. Also, in-mold flowability is improved, flashes are difficult to be formed and thus injection moldabilities are improved. Mixing PPE makes it possible to prepare sheets with excellent gloss having significantly improved surface smoothness as compared to sheets prepared using PAS alone. This is assumed to be because the presence of PPE has influence on the crystallization rate of PAS. In addition, PPE has smaller dielectric dissipation factor than PAS and serves as a modifier of dielectric properties (dielectric loss) of PAS in the present invention. Mixing PPE having high glass transition temperature (about 220°C) also improves stability of dielectric properties, linear expansion coefficient and rigidity in high temperature regions of the glass transition temperature (about 90°C) of PAS or higher.

The compatibility-imparting agent (c) in the present invention acts as an emulsifying dispersant when mixing a polyarylene sulfide resin of component (a) and a polyphenylene ether resin of component (b), and has a significant effect on the drawdown resistance of the molten resin composition when preparing an extruded sheet of the present invention by extrusion.

The compatibility-imparting agent of component (c) is a styrene copolymer containing an epoxy group and/or a styrene copolymer containing an oxazolyl group. The monomer containing styrene as a main component herein described causes no problem when the monomer is composed of 100% by weight of a styrene component. However, as styrene and the other copolymerizable monomer coexist, the copolymer contains 65% by weight or more, more preferably 75 to 95% by weight of a styrene monomer in order for the copolymer chain to maintain compatibility with component (b), a polyphenylene ether resin. Specific examples thereof include copolymers of an unsaturated monomer containing an epoxy group and/or an oxazolyl group and a styrene monomer and copolymers of an unsaturated monomer containing an epoxy group and/or an oxazolyl group and styrene/acrylonitrile of 90 to 75% by weight/10 to 25% by weight.

Examples of epoxy group-containing unsaturated monomers described above include glycidyl methacrylate, glycidyl acrylate, vinyl glycidyl ether, glycidyl ether of hydroxyalkyl (meth) acrylate, glycidyl ether of polyalkylene glycol (meth)acrylate and glycidyl itaconate. Of these, glycidyl methacrylate is preferred. As the oxazolyl group-containing unsaturated monomer described above, 2-isopropenyl-2-oxazoline, for example, is industrially available and can be preferably used.

The other unsaturated monomers to be copolymerized with the unsaturated monomers containing an epoxy group and/or an oxazolyl group include, in addition to styrene which are essential components, copolymerization components such as vinyl cyanate monomers such as acrylonitrile, vinyl acetate and (meth)acrylic ester. It is essential that the compatibility-imparting agent in the present invention contains 65% by weight or more of a styrene monomer in the components excluding the unsaturated monomer containing an epoxy group and/or an oxazolyl group. The copolymer of component (g) must contain 0.3 to 20% by weight, preferably 1 to 15% by weight, more preferably 3 to 10% by weight of the unsaturated monomer containing an epoxy group and/or an oxazolyl group. When the amount of the unsaturated monomer containing an epoxy group and/or an oxazolyl group in the copolymer of component (g) is 0.3% by weight or more and 20% by weight or less, the compatibility of a polyarylene sulfide resin of component (a) and a polyphenylene ether resin of component (b) is improved, making it possible to significantly suppress drawdown properties in extrusion using the resulting resin composition. Moreover, in addition to the advantage of reducing flashes in injection molding, a significant effect on the heat resistance, toughness (impact strength) and mechanical strength of high-frequency electronic part materials is brought about

Examples of copolymers of component (c) prepared by copolymerization of these copolymerizable unsaturated monomers include styrene-glycidyl methacrylate copolymers, styrene-glycidyl methacrylate-methyl methacrylate copolymers, styrene-glycidyl methacrylate-acrylonitrile copolymers, styrene-vinyl oxazoline copolymers and styrene-vinyl oxazoline-acrylonitrile copolymers.

The styrene copolymer containing an acid anhydride group of (2) means a copolymer of an acid anhydride group-containing unsaturated compound such as maleic anhydride, phthalic anhydride or itaconic anhydride, preferably maleic anhydride, and a styrene monomer.
In the present invention, for the mixing ratio of component (a) and component (b), preferably 40 to 99% by weight, more preferably 60 to 80% by weight of (a) a polyarylene sulfide resin is contained and preferably 1 to 60% by weight, more preferably 20 to 40% by weight of (b) a polyphenylene ether resin is contained in consideration of processability, in particular, a drawdown improving effect in extrusion of a thickness of 100 µm, a flash preventing effect in injection molding and dielectric properties.

Further, the compatibility-imparting agent of component (c) is mixed in an amount of 1 to 20 parts by weight, preferably 5 to 15 parts by weight based on 100 parts by weight of the sum of component (a) and component (b).
When the mixing amount of component (c) is 1 part by weight or more, the compatibility of a polyarylene sulfide resin of component (a) and a polyphenylene ether resin of component (b) is improved. When the mixing amount is 20 parts by weight or less, the component has a significant effect on heat resistance (impact strength), toughness and mechanical strength in addition to being able to improve sheet extrusion moldabilities and injection processability.

The resin composition of the present invention is used after mixing the inorganic filer (d) to components (a) to (c) for improving dielectric constant. Graphite having an average particle size of 10 to 100 µm is used as a non-fibrous inorganic filler.Graphite having an average particle size of 20 µm or more and 80 µm or less is more preferred, and graphite having an average particle size of 60 µm is most preferred. For the graphite controlled to a specific particle size used in the present invention, particles having an average particle size of 100 µm or less may be generally prepared by a mechanical pulverization method of natural graphite or artificial graphite using a pulverizer such as a grain mill, a Victory Mill, a stamp mill, a ball mill, a jet mill or a high speed rotary mill. The graphite prepared by such a method may be further surface-treated with a surface treating agent such as a silane coupling agent, a titanate coupling agent or aliphatic metal salt, may be organized with an ammonium salt or the like by an intercalation method, or may be treated with a binder, i.e., a urethane resin or an epoxy resin, so as to improve dispersibility in a resin.

The amount of the graphite component (d) to be added is 1 to 15% by weight based on the entire resin composition so as to improve the dielectric constant. It is preferably 10% by weight or less. When the amount added of the graphite is large, the resulting shaped article disadvantageously has higher electric conductivity and higher dielectric dissipation factor. The graphite, component (d), has higher effect of increasing the dielectric constant of a resin composition in proportion to the ratio of addition. While the effect depends on the mixing composition of the resin composition, when the amount added of the graphite is 5% by weight, the dielectric constant can be increased to 4 to 5. Since a resin composition having high dielectric constant can be prepared by adding a small amount of graphite, a desired resin composition for an antenna substrate can be prepared without deteriorating the mechanical properties and the physical properties such as moldability of the resin composition. The fact is worth noticing. The graphite of component (d) has an average particle size of 10 to 100 µm preferably 20 to 80 µm. The best dielectric properties cannot be achieved when the average particle size is too large or too small. The average particle size has influence on the morphology of dispersion of graphite and the electric conductivity, i.e., dielectric properties.

The extruded sheet of the present invention has a multilayer structure. The extruded sheet is a multilayer sheet composed of an outer layer of a resin composition containing components (a) to (c) as main components and an inner layer of a graphite-added resin composition containing components (a) to (d).

In addition to the above components, a thermoplastic elastomer such as polybutadiene, polyisoprene, a styrene-butadiene copolymer, a butadiene-isoprene copolymer, an ethylene-propylene copolymer, a hydrogenated styrene-butadiene block copolymer or a hydrogenated styrene-isoprene block copolymer may be added to the resin composition and the multilayer extruded sheet of the present invention. In particular, to improve toughness and sheet extrusion moldabilities, a hydrogenated styrene-butadiene block copolymer is preferably added within a range that does not deteriorate the characteristics of the present invention. Also, various additives such as inorganic fillers, heat stabilizers, ultraviolet absorbers, flame retardants, release agents, lubricants, dyes and pigments may be added without any particular limitation within a range that does not deteriorate the characteristics of the present invention.

A single layer extruded sheet and a multilayer extruded sheet prepared by molding the graphite-added resin composition of the present invention or a molded article prepared by injection molding of the resin composition of the present invention are suitably used as an antenna part or a substrate after stacking metal foil or metal plating on the surface and patterning. A multilayer extruded sheet prepared by adding metal oxide to the inner layer is also suitably used as an antenna substrate.

The resin composition and the shaped article of the present invention have electric properties of a dielectric constant of 3 to 10 and a dielectric dissipation factor of 0.007 or less at 1 GHz. Although dielectric constants and dielectric dissipation factors vary depending on the composition of a resin composition, for high frequency use requiring only low dielectric loss properties, the better the lower the dielectric dissipation factor, because the lower the dielectric dissipation factor, the lower the dielectric loss. The dielectric dissipation factor is preferably 0.007 or less, more preferably 0.005 or less. In applications such as an antenna substrate that require downsizing, in other words, in applications that require high dielectric constant, a resin composition and a shaped article which have a dielectric constant of 5 to 10 are used. The dielectric constant value varies depending on the properties required for products.

The resin composition and the shaped article of the present invention can be suitably used for a copper-clad laminate, which is one of the high-frequency electronic and electric parts. By stacking copper foil on the surface of the extruded sheet of the present invention, a copper foil laminated plate can be prepared. The copper foil herein used has a thickness of about 3 to 200 µm, preferably 6 to 70 µm. While copper foils include rolled copper foils and electrolytic copper foils, electrolytic copper foils are generally used for uses that require thin foil of 50 µm or less. While electrolytic copper foil has a mat face and a smooth face due to its production process, generally the mat face is attached to a plate-like shaped article. The irregular face produces an anchoring effect and increases the adhesion strength with an extruded sheet. The copper foil is subjected to surface roughening, chemical functionalization, adhesive application, heat discoloration prevention or rust proofing in order to improve adhesion strength depending on the purpose of use. The thickness of the copper foil is determined based on sizes of substrates, accuracy of etching patterns and the amount of current flowing through substrates. For copper plating, electroless plating is performed to a thickness of preferably 1 µm or more. The product is suitably used for a small substrate or a molded article.

While the shaping method of the resin shaped article to which graphite is added of the present invention is not particularly limited, injection molding, extrusion and press molding are preferably employed. Injection molding is effective for small products. Extruded sheets formed by extrusion are most preferred. Multi-layer extruded sheets of the present invention, for example, extruded sheets composed of three resin layers, can be prepared at a time by extrusion using a multilayer die and a plurality of extruders. While manifold multilayer dies are preferably used, multilayer molding by a feed block system may also be employed. Moreover, for preparing a multilayer extruded sheet having a thickness of 0.02 mm or less, inflation molding is effective.

The extruded sheet of the present invention is used in a thickness range of 0.01 to 5 mm. An extruded sheet having a thickness of 1.0 mm or less is suitably used as a flexible substrate, while an extruded sheet having a thickness of more than 1.0 mm is suitably used as a rigid substrate.

In sheet extrusion using a resin composition to which a large amount of metal oxide is added, the surface of a molten sheet extruded through the die tends to be rough and gum often adheres to the die. As described above, making a multilayer structure by applying and stacking a resin layer to which no metal oxide is added suppresses formation of gum and improves sheet extrusion moldabilities (drawdown resistance), making it possible to form an extruded sheet having a smooth surface, superior notch sensitivity and good appearance.

The thickness of the outer layer to which no metal oxide is added is related to the thickness of a plate-like shaped article excluding copper foil from a copper-clad laminate. The outer layer has a thickness of preferably 1/20 to 1/4, more preferably 1/10 to 1/5 of the overall thickness of the plate-like shaped article.

When using the extruded sheet of the present invention for a copper-clad laminate, copper foil may be continuously stacked by heating in extrusion of plate-like sheet, or copper foil may be attached to the sheet surface by heating (e.g., at 200 to 250°C) after forming a sheet. Alternatively, copper foil may be stacked by dry lamination by applying an adhesive. Also, copper foil may be put over an extruded sheet and attached to the sheet by pressing by a hot press. As described above, the copper cladding step of a copper-clad laminate is not particularly limited.

### Examples

In the following, the present invention is described by means of Examples and Comparative Examples.

Raw materials used for the resin composition are as follows.

### Polyarylene sulfide resin of component (a)

A linear polyphenylene sulfide resin comprising a p-phenylene sulfide repeat unit having a melt viscosity (measured after retaining at 300°C, a load of 196 N and L/D of 10/1 for 6 minutes using FLOW TESTER) of 500 poise, an extract amount with methylene chloride of 0.4% by weight and a terminal SX group amount of 26 µmol/g was prepared in accordance with Example 1 of JP-A-8-253587.

### Polyphenylene ether resin of component (b)

2,6-xylenol was subjected to oxidation polymerization to give polyphenylene ether.

### Compatibility-imparting agent of component (c)

A styrene-glycidyl methacrylate copolymer (weight average molecular weight: 110,000) containing 5% by weight of glycidyl methacrylate was prepared by radical polymerization.

### Graphite of component (d)

Graphites in a flake form having an average particle size of 5 µm (trade name J-CPB available from Nippon Graphite Industries, Ltd.), 12 µm (trade name CP series CSP manufactured by the same), 19 µm (trade name CPB manufactured by the same), 60 µm (trade name F#3 manufactured by the same), 130 µm (trade name F#2 manufactured by the same), and particulate graphite having an average particle size of 20 µm (trade name CGB manufactured by the same) were used.

### Examples 1 to 4, Comparative Examples 1 to 4

A T die having a die width of 750 mm and a lip width of 0.5 mm was attached to a single screw extruder of 65 mmφ and L/D of 28 with a sub extruder, which is capable of multilayer molding. At a cylinder set temperature of 300°C, the graphite-added resin compositions shown in Table 1 were extruded into a single layer and the titanium oxide-added resin compositions shown in Table 2 were extruded into a single layer and multilayers to give extruded sheets having a width of 700 mm and a thickness of 500 µm.

Sheet extrusion moldabilities of the resin compositions and dielectric properties of the extruded sheets at 25°C and 1 GHz are shown in Table 3.

The resin composition of Example 4 to which the amount of graphite added is 10% by weight was difficult to extrude due to occurrence of drawdown. However, other resin compositions to which the amount of graphite added is 5% by weight or less have good sheet extrusion moldabilities.

The sheet of Example 1 to which graphite having an average particle size of 20 µm was added and the sheets of Examples 2 to 4 to which graphite having an average particle size of 60 µm was added have a dielectric dissipation factor of 0.0025 or less. The results show that these sheets have smaller dielectric dissipation factor and superior dielectric properties compared to the sheet of Comparative Example 1 having a dielectric dissipation factor of 0.0045 to which graphite having an average particle size of 5 µm was added and the sheet of Comparative Example 2 having a dielectric dissipation factor 0.0038 to which graphite having an average particle size of 130 µm was added.

Further, the sheet of Comparative Example 3 to which the amount of graphite having an average particle size of 60 µm is 15% by weight has a dielectric dissipation factor of as large as 0.0072, showing poor dielectric loss properties.

Moreover, the sheet of Example 4 to which the amount of graphite added is 10% by weight has a dielectric constant of 4.95 and a dielectric dissipation factor of 0.0025. This shows that a resin composition to which graphite is added has an outstanding effect of improving dielectric constant with a smaller amount of addition as compared to a resin composition to which metal oxide is added.

Table 4 shows the temperature dependency of the dielectric properties and the temperature dependency of the linear expansion coefficient of the sheets prepared by molding the resin compositions of Example 3 and Comparative Example 4. The alloy resin composition of a polyphenylene sulfide resin and a polyphenylene ether resin of Example 3 has smaller change of dielectric dissipation factor at 100°C to 140°C as compared to the polyphenylene sulfide resin single body of Comparative Example 4. The result shows that the alloy resin composition has stable dielectric properties at high temperatures. Also, the alloy resin composition of a polyphenylene sulfide resin and a polyphenylene ether resin has a lower rate of change of linear expansion coefficient at 80 to 150°C. The result shows that the alloy resin composition has good dimensional stability at high temperatures.

The resulting copper-clad laminate has good moldability and fully satisfies properties necessary for a copper-clad laminate used in the field of high frequency band telecommunications.

**[Table 1]**

| | | | | | | % by weight | |
|---|---|---|---|---|---|---|---|
| | Ex. 1 | Ex. 2 | Ex. 3 | Ex. 4 | Comp. Ex. 1 | Comp. Ex. 2 | Comp. Ex. 3 |
| (a)PPS | 56 | 57.2 | 56 | 53.1 | 56 | 56 | 50.1 |
| (b) PPE | 23 | 23.3 | 23 | 21.6 | 23 | 23 | 20.4 |
| (c) Compatibility-imparting agent styrene-glycidyl methacrylate (glycidyl content: 5% by weight Mw=110 000) | 3 | 2.9 | 3 | 2.7 | 3 | 3 | 2.5 |
| Hydrogenerated styrene-butadiene copolymer | 13 | 13.6 | 13 | 12.6 | 13 | 13 | 12 |
| (d) Graphite | In flake form, average particle size: 20 µm | In flake form, average particle size 60 µm | | | In flake form, average particle size 5 particle size µm | In flake form, average 130 µm | In flake form, average particle size: 60 µm |
| | 5 | 3 | 5 | 10 | 5 | 5 | 15 |

**[Table 2]**

| | % by weight |
|---|---|
| | Comp. Ex. 4 |
| (a) PPS | 100 |
| (b) PPE | - |
| (c) Compatibility-imparting agent styrene-glycidyl methacrylate (glycidyl content: 5% by weight. Mw=110.000) | - |
| Hydrogenated styrene-butadiene copolymer | - |

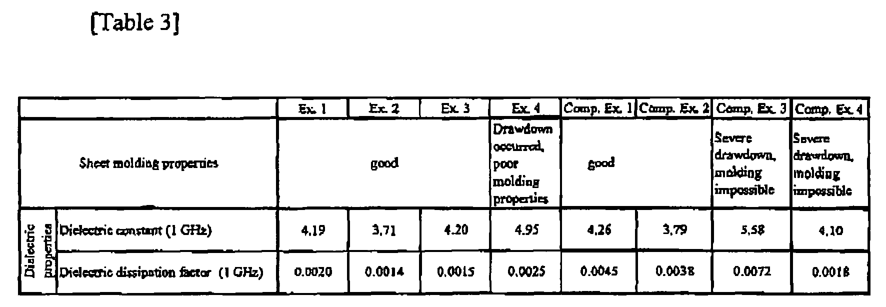

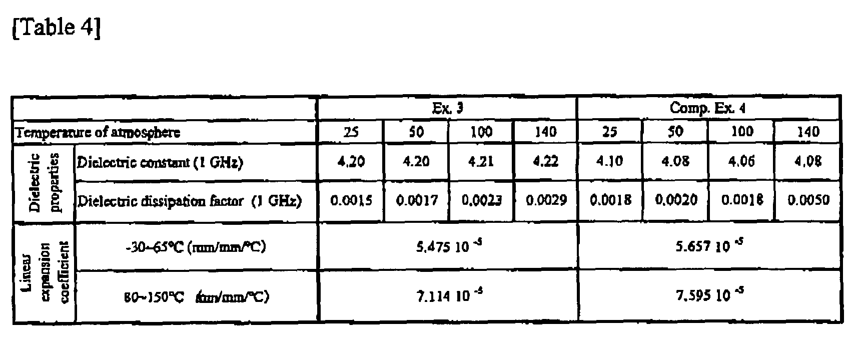

### Industrial Applicability

The present invention can be suitably used for fluororesin copper-clad laminates and BT resin copper-clad laminates that have been used in the high frequency band telecommunication field. For example, the present invention can be used for flat antennas and filters for high frequency use. Further, since the resin composition of the present invention is composed of a thermoplastic resin composition, the resin composition has good fabrication properties and can also be used as curved antennas after subjecting to post thermal processing.

## Claims

1. A low dielectric loss resin composition for high-frequency electronic and electric parts, having dielectric properties of a dielectric constant of 3 to 10 and a dielectric dissipation factor of 0.007 or less at 1 GHz, wherein
the resin composition is obtainable by melt kneading a raw material composition comprising:
(a) 5 to 95% by weight of a polyarylene sulfide resin,
(b) 95 to 5% by weight of a polyphenylene ether resin,
(c) 1 to 20 parts by weight of a styrene copolymer comprising 65 % by weight or more of a styrene monomer and 0.3 to 20 % by weight of an unsaturated monomer containing an epoxy group and/or an oxazolyl group, based on 100 parts by weight of components (a) and (b), and
(d) 1 to 15 parts by weight of graphite having an average particle size of 10 to 100 µm, based on 100 parts by weight of components (a), (b) and (c).

2. The low dielectric loss resin composition according to claim 1, wherein the raw material composition further comprises a thermoplastic elastomer selected from polybutadiene, polyisoprene, a styrene-butadiene copolymer, a butadiene-isoprene copolymer, an ethylene-propylene copolymer, a hydrogenated styrene-butadiene block copolymer, and a hydrogenated styrene-isoprene block copolymer.

3. A shaped article prepared by shaping the resin composition according to claim 1 or 2.

4. The shaped article of claim 3 being a single layer extruded sheet.

5. A high-frequency multilayer sheet comprising an outer layer and an inner layer, wherein the outer layer and the inner layer are each composed of the shaped article according to claim 3.

6. The multilayer sheet according to claim 5, wherein the inner layer is a shaped article prepared by shaping the resin composition according to claim 1 or 2.

7. The multilayer sheet according to claim 5, wherein a raw material composition of the shaped article constituting the inner layer further comprises (e) 10 to 60 parts by weight of a metal oxide based on 100 parts by weight of components (a), (b) and (c).

8. The multilayer sheet according to any one of claims 5 to 7, wherein the multilayer sheet has an overall thickness of 0.01 to 5 mm and the outer layer has a thickness of 1/20 to 1/4 of the overall thickness of the multilayer sheet.

9. The multilayer sheet according to any one of claims 5 to 7, which is a copper-clad laminate.

## Patentansprüche

1. Harzzusammensetzung mit niedrigem dielektrischen Verlust für elektronische und elektrische Hochfrequenzteile, die dielektrische Eigenschaften mit einer Dielektrizitätskonstanten von 3 bis 10 und einem dielektrischen Verlustfaktor von 0,007 oder weniger bei 1 GHz aufweisen, wobei die Harzzusammensetzung durch Schmelzkneten einer Rohstoffzusammensetzung erhältlich ist, die Folgendes umfasst:
(a) 5 bis 95 Gew.-% eines Polyarylensulfidharzes;
(b) 95 bis 5 Gew.-% eines Polyphenylenetherharzes;
(c) 1 bis 20 Gewichtsteile eines Styrol-Copolymers, das 65 Gew.-% oder mehr eines Styrolmonomers und 0,3 bis 20 Gew.-% eines ungesättigten Monomers, das eine Epoxidgruppe und/oder eine Oxazolylgruppe enthält, umfasst, bezogen auf 100 Gewichtsteile der Komponenten (a) und (b); und
(d) 1 bis 15 Gewichtsteile Graphit mit einer mittleren Teilchengröße von 10 bis 100 µm, bezogen auf 100 Gewichtsteile der Komponenten (a), (b) und (c).

2. Harzzusammensetzung mit niedrigem dielektrischen Verlust gemäß Anspruch 1, wobei die Rohstoffzusammensetzung weiterhin ein thermoplastisches Elastomer umfasst, das aus Polybutadien, Polyisopren, einem Styrol-Butadien-Copolymer, einem Butadien-Isopren-Copolymer, einem Ethylen-Propylen-Copolymer, einem hydrierten Styrol-Butadien-Blockcopolymer und einem hydrierten Styrol-Isopren-Blockcopolymer ausgewählt ist.

3. Formkörper, der durch Formen der Harzzusammensetzung gemäß Anspruch 1 oder 2 hergestellt ist.

4. Formkörper gemäß Anspruch 3, bei dem es sich um eine einschichtige extrudierte Bahn handelt.

5. Mehrschichtige Hochfrequenzbahn, die eine äußere Schicht und eine innere Schicht umfasst, wobei die äußere Schicht und die innere Schicht jeweils aus dem Formkörper gemäß Anspruch 3 bestehen.

6. Mehrschichtige Bahn gemäß Anspruch 5, wobei die innere Schicht ein Formkörper ist, der durch Formen der Harzzusammensetzung gemäß Anspruch 1 oder 2 hergestellt ist.

7. Mehrschichtige Bahn gemäß Anspruch 5, wobei eine Rohstoffzusammensetzung des Formkörpers, der die innere Schicht bildet, weiterhin (e) 10 bis 60 Gewichtsteile eines Metalloxids umfasst, bezogen auf 100 Gewichtsteile der Komponenten (a), (b) und (c).

8. Mehrschichtige Bahn gemäß einem der Ansprüche 5 bis 7, wobei die mehrschichtige Bahn eine Gesamtdicke von 0,01 bis 5 mm aufweist und die äußere Schicht eine Dicke von 1/20 bis 1/4 der Gesamtdicke der mehrschichtigen Bahn aufweist.

9. Mehrschichtige Bahn gemäß einem der Ansprüche 5 bis 7, bei der es sich um ein kupferkaschiertes Laminat handelt.

## Revendications

1. Composition de résine à basses pertes diélectriques pour composants électroniques et électriques à haute fréquence, ayant comme propriétés diélectriques une constante diélectrique de 3 à 10 et un facteur de dissipation diélectrique de 0,007 ou moins à 1 GHz, dans laquelle la composition de résine peut être obtenue par malaxage à l'état fondu d'une composition de matière première comprenant :
(a) 5 à 95 % en poids d'une résine de sulfure de polyarylène ;
(b) 95 à 5 % en poids d'une résine d'éther polyphénylénique ;
(c) 1 à 20 parties en poids d'un copolymère de styrène comprenant 65 % en poids ou plus d'un monomère de styrène et 0,3 à 20 % en poids d'un monomère insaturé contenant un groupe époxy et/ou un groupe oxazolyle, par rapport à 100 parties en poids des composants (a) et (b) ; et
(d) 1 à 15 parties en poids de graphite ayant une granulométrie moyenne de 10 à 100 µm, par rapport à 100 parties en poids des composants (a), (b) et (c).

2. Composition de résine à basses pertes diélectriques selon la revendication 1, dans laquelle la composition de matière première comprend en outre un élastomère thermoplastique choisi parmi le polybutadiène, le polyisoprène, un copolymère de styrène-butadiène, un copolymère de butadiène-isoprène, un copolymère d'éthylène-propylène, un copolymère séquencé de styrène-butadiène hydrogéné et un copolymère séquencé de styrène-isoprène hydrogéné.

3. Pièce façonnée produite par façonnage de la composition de résine selon la revendication 1 ou 2.

4. Pièce façonnée selon la revendication 3, qui est une feuille extrudée à couche unique.

5. Feuille multicouche à haute fréquence, comprenant une couche extérieure et une couche intérieure, dans laquelle la couche extérieure et la couche intérieure sont chacune composées de la pièce façonnée selon la revendication 3.

6. Feuille multicouche selon la revendication 5, dans laquelle la couche intérieure est une pièce façonnée produite par façonnage de la composition de résine selon la revendication 1 ou 2.

7. Feuille multicouche selon la revendication 5, dans laquelle une composition de matière première de la pièce façonnée constituant la couche intérieure comprend en outre (e) 10 à 60 parties en poids d'un oxyde métallique, par rapport à 100 parties en poids des composants (a), (b) et (c).

8. Feuille multicouche selon l'une quelconque des revendications 5 à 7, dans laquelle la feuille multicouche a une épaisseur totale de 0,01 à 5 mm, et la couche extérieure a une épaisseur de 1/20 à 1/4 de l'épaisseur totale de la feuille multicouche.

9. Feuille multicouche selon l'une quelconque des revendications 5 à 7, qui est un stratifié plaqué de cuivre.
